# EUROPEAN PATENT APPLICATION

(11) **EP 4 823 257 A1**
(43) Date of publication of application: **14.10.2026**
(21) Application number: 25168776.0
(22) Date of filing: 07.04.2025
(51) Int. Cl.: H05K 7/20, H05K 5/06, H01L 23/473

(54) **EXTENDED HEATSINK FOR AN IMMERSION COOLING SYSTEM WITH AN INSERTABLE PLUG**

(71) Applicant: LiquaCool IP LLC, Lakeside, MT 59922 (US)
(72) Inventor: Sivertsen, Clas, 6508 Kristiansund N (NO)
(74) Representative: Derry, Paul Stefan

(57) **Abstract**

A hybrid cooling system coupled to a printed circuit board (870) to provide cooling for a component (840) mounted on the printed circuit board, the hybrid cooling system comprising an extended heatsink (810) coupled to the printed circuit board (870) to form a sealed chamber (815) with the printed circuit board (870), the extended heatsink having an interior surface and an exterior surface, and a contact area (820) on the interior surface of the extended heatsink, the contact area (820) designed to be in direct physical contact with a top of the component (840), to provide direct contact cooling to the component. The system further comprising a transfer fluid (850) within the sealed chamber (815) and contacting other areas of the component (840) mounted on the printed circuit board to provide liquid cooling for the component.

## Description

### Field

The present application relates to thermal management systems, specifically to an extended heatsink which provides a liquid cooling extended heatsink integrated with a printed circuit board (PCB) to dissipate heat generated by electronic components.

### Background

Integrated circuits (ICs) such as central processing units (CPUs), systems on a chip (SOCs), graphics processors (GPUs), tensor processing units (TPUs), neural processing units (NPUs), field-programmable gate arrays (FPGAs), and application-specific integrated circuits (ASICs), power transistors, DC-DC converters, power controllers with integrated switching transistors, triacs, thyristors, diode bridge rectifiers, insulated-gate bipolar transistors (IGBTs), voltage regulators, motor drivers, power factor correction (PFC) circuits, load switches, and others produce heat during operation. These components must be adequately cooled to maintain optimal performance and prevent failure.

In the prior art, various heat dissipation methods have been employed to absorb and remove heat from the ICs and redistribute it away from the hardware.

Traditionally, cooling methods have relied on a combination of heatsinks and fans, where air is moved across the heatsink to dissipate heat. However, such methods are often insufficient for managing the thermal demands of modern, high-performance components.

One prior art solution is liquid cooling. In this system, rather than air, a liquid such as water or a specialized dielectric fluid circulates to remove heat. The system generally consists of a baseplate connected to the metal lid of a CPU via thermal paste. The baseplate forms part of a water block that is filled with coolant. As the coolant absorbs heat from the baseplate, it is transferred through the water block and then routed to a radiator. At the radiator, the liquid is exposed to air for cooling, with fans often used to accelerate heat removal. The coolant then re-enters the water block, completing the cycle.

Semiconductor components exhibit a characteristic known as thermal runaway; wherein power consumption increases exponentially with rising temperature. As the die temperature rises, the power required to perform the same computational operations increases, exacerbating the thermal load. Without efficient heat removal, this thermal runaway can escalate, leading to critical temperature levels in semiconductor systems.

Traditionally, cooling semiconductor dies involve two approaches. The first involves heat dissipation through the top surface of the die, with thermal paste bridging the die to a metal heatsink, which is cooled by air or liquid. The second approach leverages ground pads connected to the package via gold wires, which are linked to the printed circuit board (PCB). This allows some heat to be transferred from the die through pins or balls to the PCB. Though relatively inefficient, even these incremental contributions help alleviate heat in high-performance systems.

The combined effect of these traditional cooling methods is in line with the principle of superposition, where every thermal gradient-any interface or material transition where temperature differences exist-contributes to reducing the internal temperature of the semiconductor die. Nevertheless, even with state-of-the-art conductive cooling techniques, high-performance semiconductor devices often exhibit internal die temperatures exceeding 100°C in ambient environments of 30°C.

To further manage die temperature, many systems incorporate thermal sensors that monitor temperature levels and initiate throttling or other thermal management strategies when critical thresholds are approached.

While immersion cooling has been practiced for many years in the electronics industry, it presents several drawbacks because entire motherboards or subassemblies must be submerged in a liquid bath. In such configurations, interconnects, such as wires and cables, must exit the liquid, leading to complex and often cumbersome installations. Additionally, the need for large volumes of liquid makes the system expensive, prone to liquid loss through evaporation, and difficult to manage.

### BRIEF DESCRIPTION OF THE FIGURES

The present invention is illustrated by way of example, and not by way of limitation, in the figures of the accompanying drawings and in which like reference numerals refer to similar elements and in which:
Figure 1A is a perspective view of an exemplary assembled extended heatsink on a printed circuit board, including two fans.
Figure 1B is a top view of the system of Figure 1A.
Figures 1C and 1D show a closer-up of the fill hole for the extended heatsink and a fastener to seal the fill hole.
Figure 1E shows another configuration of the fill hole for the extended heatsink.
Figure 2A illustrates an exemplary assembled extended heatsink, without the fans.
Figure 2B illustrates the board, with the exemplary extended heatsink removed, but the gasket in place.
Figure 3A and 3B show illustrations of the front and back of an exemplary PCB, with the components removed.
Figure 3C shows a close-up of the X-gasket of Figure 3B.
Figures 4A-4B show an X-gasket for sealing the extended heatsink against a board.
Figure 5A is an illustration of a top of an exemplary extended heatsink showing a high heat conductivity area within the heatsink.
Figure 5B shows the interior of the extended heatsink of Figure 5A, showing the high conductivity plug.
Figure 6 shows the interior of an exemplary extended heatsink showing a high conductivity area extending over the entire interior.
Figures 7A-7C illustrate various embodiments of the attachment points for the extended heatsink, and attachment point spacing.
Figure 8A illustrates a cross-section of an exemplary system including an extended heatsink with hybrid cooling.
Figure 8B illustrates a top view of the system of Figure 8A, showing a subset of the elements as transparent.
Figures 8C and 8D illustrate a cross section and top view of the system of Figure 8A, with the addition of a secondary cooling flow.
Figures 8E illustrates a cross section and top view of the system of Figure 8A, with an external piezoelectric pump.
Figure 8F illustrates a cross-section of the piezoelectric pump and liquid tube.
Figure 9A illustrates a cross-section of an exemplary system including an extended heatsink with hybrid cooling.
Figure 9B illustrates a top view of the system of Figure 9A, showing a subset of the elements as transparent.
Figures 9C and 9D illustrate the position of a liquid tube for a configuration in which the printed circuit board is positioned vertically.
Figure 10 illustrates an exemplary single-sided extended heatsink micro thermal management system.
Figure 11A illustrates an exemplary single-sided extended heatsink micro thermal management system with a plug.
Figure 11B illustrates the single-sided micro thermal management system with a plug, showing a plurality of fans.
Figure 12A illustrates a multi-component system including plugs.
Figures 12B-12D illustrate top/bottom views of various configurations of the extended heatsink showing placements of plugs.
Figures 13A and 13B illustrate a portion of an extended heatsink and an exemplary configuration of an associated plug.
Figures 14A and 14B illustrate a portion of an extended heatsink and exemplary configuration of an associated plug.
Figures 15A and 15B illustrate a portion of an extended heatsink and exemplary configuration of an associated plug.
Figure 16A illustrates a cross-section of the micro thermal management system including intra-chip holes for liquid cooling.
Figure 16B illustrates a cross-section of the micro thermal management system including intra-chip holes for liquid cooling.
Figure 17A illustrates an extended heatsink with a sensor and liquid mover within a chamber formed by the extended heatsink.
Figure 17B illustrates a configuration of the extended heatsink including a gas bladder in the chamber formed by the extended heatsink.
Figure 17C illustrates a gas bladder with a fill hole.
Figures 17D-17L show various configurations of a gas bladder within the extended heatsink.

### DETAILED DESCRIPTION

The present invention describes a micro thermal management system which includes an extended heatsink coupled to a printed circuit board. The extended heatsink comprises a heatsink portion which is in mechanical contact with a top of a component to be cooled and has an extended area or skirt which extends past the edges of the component and is coupled to the printed circuit board to create an enclosed chamber that is filled with a transfer fluid. The transfer fluid has a high heat transfer coefficient but is not electrically conductive (i.e., is electrically insulating). The transfer fluid may be a single phase or a two-phase fluid (which turns from liquid to gas at a known temperature). The micro thermal management (µTM) system can provide board-level cooling, chip level cooling, cooling one or more components on a printed circuit board. Since the top of the component being cooled is in physical (mechanical) contact with the extended heatsink, the system provides contact-based heatsink-type cooling. Thus, the system provides a combination of contact-based cooling for a top of a component and fluid-based cooling for other parts of the component on a printed circuit board.

In various embodiments, a gasket may be used to securely attach the extended heatsink to the printed circuit board to create a chamber that does not leak. In various embodiments, the gasket may be an X-gasket. The gasket may be made of any flexible deformable material which can be used for sealing. In various embodiments, the X-gasket is placed over a silk screen layer on the printed circuit board. In various embodiments, the silk screen layer may be two superimposed layer to provide a smooth surface over traces on the printed circuit board and a liquid barrier.

The portion of the extended heatsink in contact with the top of the component, referred to as the contact area. The contact area may be made of a high thermal conductivity material, such as red copper. Red copper is high purity copper, which is generally too soft for components, but has very high thermal conductivity. In various embodiments, the contact area is a plug, inserted into the heatsink. The contact area may be made of a different material than the rest of the heatsink. The use of a plug also enables the system to support components of various heights without requiring redesign of the extended heatsink. In various embodiments, the contact area of the heatsink may be fins or other structures which provide physical contact while permitting through-flow of the transfer fluid. In various embodiments, the portion of the extended heatsink in contact with the top of the component may have liquid through-holes which enabling the transfer fluid to pass through a portion of the extended heatsink.

In various embodiments, a sensor may be present within the chamber. The sensor may be a pressure sensor and/or temperature sensor. The system may include a liquid tube to move liquid from a colder area to a hotter area and ensure movement of the transfer fluid. In various embodiments, the system may include a liquid mover, such as a motor, to ensure that the transfer fluid circulates around the chamber. In various embodiments, the micro thermal management system may further include a gas bladder within the chamber, in addition to a sensor. The gas bladder expands and contracts to facilitate a balance of pressure within an interior of the chamber. In some embodiments, the bladder may have an inlet on the exterior of the extended heatsink, enabling addition or subtraction of the volume of gas in the bladder.

In various embodiments, the micro thermal management system can provide inter-chip liquid cooling, which provides improved cooling by including inter-chip liquid flow-holes underneath components, ensuring that the transfer fluid makes contact with the bottom portion of one or more components on the printed circuit board. In some embodiments, the system can provide intra-chip cooling with flow-holes through the integrated circuit packaging to allow flow of the transfer fluid closer to the heat source. Intra-chip cooling allows the transfer fluid to enter the circuit package. Because the system uses an electrically inert transfer fluid, the transfer fluid is in contact with the chip inside the package. In some embodiments, the transfer fluid makes direct contact with the die within the integrated circuit package. Additionally, the extended heatsink can protect the components from radiation as well as other potential sources of damage.

The following detailed description of embodiments of the invention make reference to the accompanying drawings in which like references indicate similar elements, showing by way of illustration specific embodiments of practicing the invention. Description of these embodiments is in sufficient detail to enable those skilled in the art to practice the invention. One skilled in the art understands that other embodiments may be utilized, and that logical, mechanical, electrical, functional, and other changes may be made without departing from the scope of the present invention. The following detailed description is, therefore, not to be taken in a limiting sense, and the scope of the present invention is defined only by the appended claims.

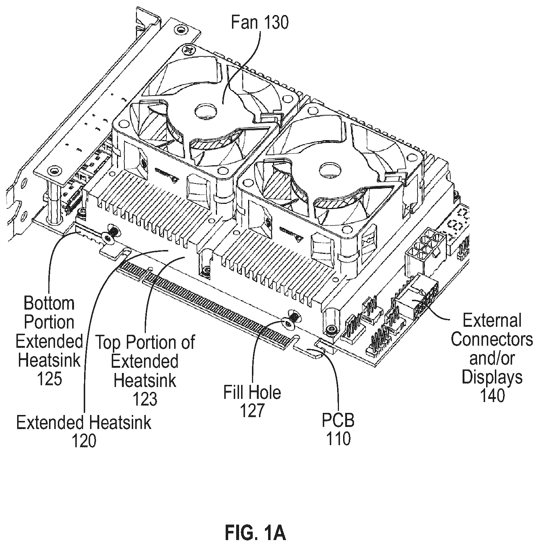

Figure 1A is a perspective view of an assembled extended heatsink on a printed circuit board, including two fans. The extended heatsink 120 is coupled to the printed circuit board (PCB) 110 to form a closed chamber. There is a transfer fluid inside the chamber which does not leak (because of the sealed chamber). In various embodiments, the transfer fluid is filled into the chamber using fill holes 127.

The top of the extended heatsink 120 may have protrusions which increase the surface area, to increase the heat dissipation. As shown in the figures, the protrusions may be ridges that extend parallel to each other. The ridges may have a square or rectangular cross section. Alternatively, the protrusions may be fingers or other elements, as is known in the art for heatsinks. In various embodiments, one or more fans 130 are coupled to the top of the extended heatsink 120 to further dissipate heat. The PCB 110 has a plurality of external connectors 140, which are not within the extended heatsink 120. The connectors 140 may be used to couple the components within the extended heatsink to external signals and systems. In various embodiments, the external connectors include outputs that are used to signal information about the interior of the extended heatsink 120. For example, a temperature and/or pressure sensor within the extended heatsink may output values through a display in the external connectors and/or displays 140, as illustrated. In various embodiments, the extended heatsink 120 may have a top portion and a bottom portion 125. In that case, liquid may flow through through-holes in the PCB 110, so that the transfer fluid circulates between the top portion 123 and the bottom portion 125 of the extended heatsink 120.

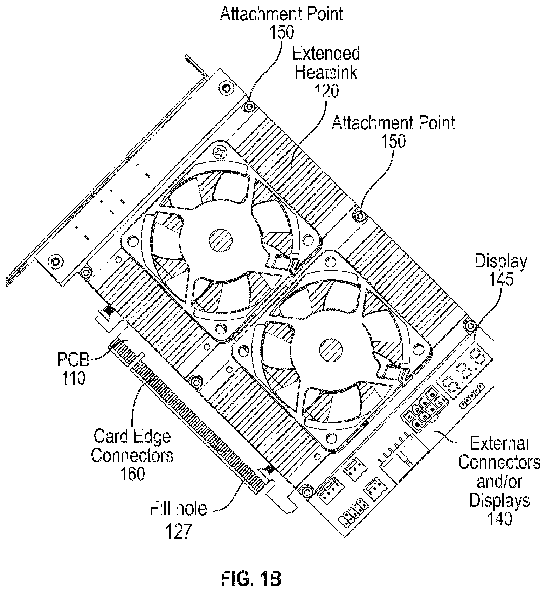

Figure 1B is a top view of the system of Figure 1A. The extended heatsink 120 is coupled to the PBC 110 via attachment points 150. The attachments in may be screws, bolts, or rivets. Alternatively, glue or other connectors or attachment mechanisms may be used. If the extended heatsink has a top portion and a bottom portion, the screws may go through the top portion and into a threaded hole in the bottom portion of the extended heatsink. The attachments may secure the extended heatsink 120 to the PBC 110, in a liquid-secure way. In one embodiment, the external connectors and/or displays 140 include a display 145 to show the pressure or temperature within the chamber formed by the extended heatsink 120. In some embodiments, the surface of the extended heatsink 120 may be treated in various ways to increase heat dissipation. The body of the extended heatsink may be made of multiple materials. In various embodiments, instead of the two fans 130 shown, there may be any number of fans from one through eight or more. In the configuration illustrated, the PCB 110 further includes a card edge connector 160 to couple the PCB into a socket. This is an optional configuration, and connectors may be on only a single side of the PCB. Other types of connectors may be used.

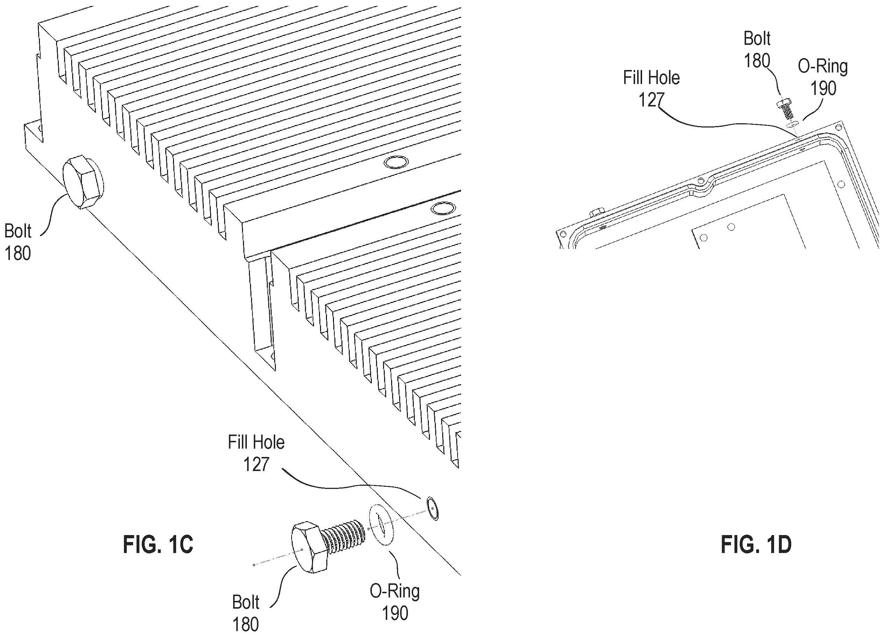

Figures 1C and 1D show a closer-up of the fill hole for the extended heatsink and a fastener to seal the fill hole. The fill hole 127 is sealed off, to ensure that the extended heatsink is leakproof. One way to seal off the fill hole 127 is by having the fill hole closed using a threaded plug or bolt 180 with a tight-fitted O-ring 190 to provide a liquid barrier. The fill hole 127 may be threaded all the way through. The hole into which the bolt is inserted may include a recessed relief for the O-ring 190. The hole may be recessed, and the bolt 180 may be a flanged bolt, to better seal the fill hole 127.

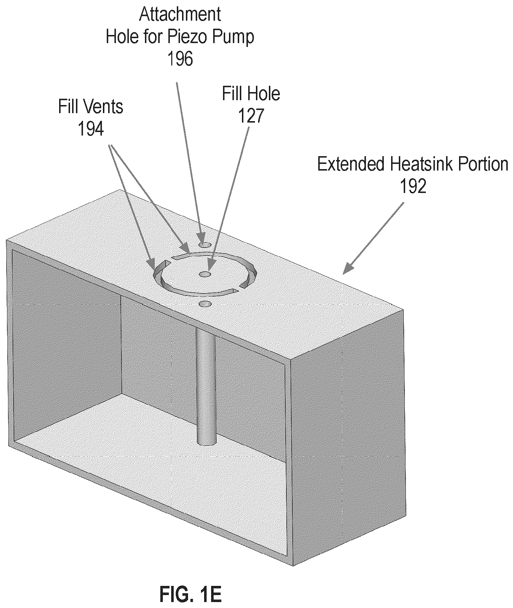

Figure 1E shows another configuration of the fill hole for the extended heatsink. In this configuration, the fill hole 127 is centered, with the fill vents 194 surrounding the fill hole, in a ring shape. The fill hole 127 and fill vents 194 are sealed by a piezoelectric pump (not shown). The pump is attached using attachment holes 196. The attachment holes are not drilled through but terminate within the wall of the extended heatsink portion 192.

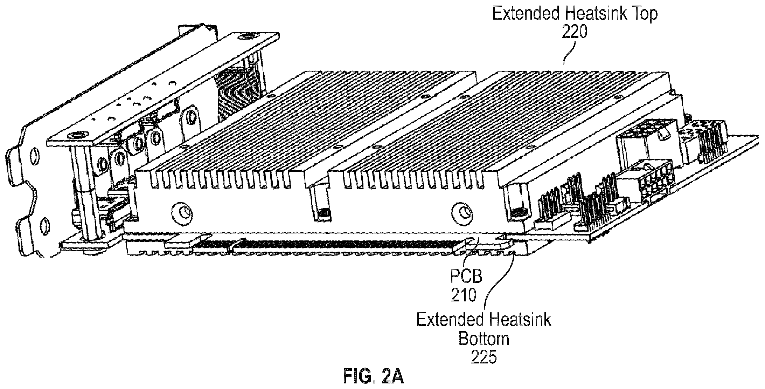

Figure 2A illustrates one example of an assembled extended heatsink, without the fans. The extended heatsink may not include any fans, as shown in Figure 2A. In another embodiment, fans may be coupled to the extended heatsink, and this is an assembly step prior to the attachment of the fans. This illustration shows the extended heatsink bottom 220 more clearly. Although the extended heatsink bottom is shown as being shorter than the extended heatsink top 220, the height of the extended heatsink depends on the height of the components enclosed within the chamber formed by the extended heatsink. In a configuration where there are components on both sides of a PCB 210, the bottom portion 225 of the extended heatsink may be the same height or higher than the top portion 220.

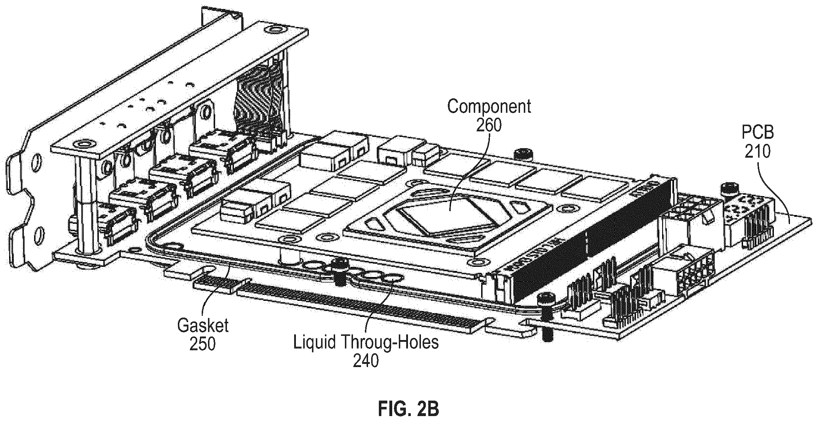

Figure 2B illustrates one example of the board, with the extended heatsink removed, but the gasket in place. As can be seen, the gasket 250. is underneath the extended heatsink, to provide a leak-proof coupling of the extended heatsink to the PCB 210. The gasket, in various embodiments is a standard gasket, which is routed around the attachment points. The gasket may be made of any material which provides sealing against leakage of the transfer fluid within the chamber. For example, the gasket may be made of natural rubber (NR), neoprene (CR), nitrile (NBR), EPDM (Ethylene Propylene Diene Monomer), silicone rubber, a vinylidene fluoride monomer based material (FKM), butyl rubber (IIR), SBR (Styrene-Butadiene Rubber), or chlorosulfonated polyethylene synthetic rubber (CSM). In various embodiments, the gasket fits within a groove in the extended heatsink and fits on top of a silk screened layer on the printed circuit board to form a liquid-tight seal.

The purpose of the extended heatsink is to provide micro thermal management (cooling) to the one or more components 260 on the PCB 210. The component 260 may be any heat-producing component on a PCB 210, such as a central processing unit (CPU), graphics processing unit (GPU), memory, etc. The system may be used with a PCB supporting any type of computer system, from servers to gaming devices, to special purpose devices such as those in vehicles or other systems, or quantum computers. The illustrated PCB 210 includes a plurality of heat producing components, including the central component, and other components. As shown in this example illustration, there are six screws for attaching the extended heatsink. Also in this illustration, the liquid through-holes 240 through which the transfer fluid passes from the top chamber to the bottom chamber is shown. In various embodiments, in addition to the visible liquid through holes seen in Figure 2A, there are additional liquid through-holes in the PCB 210. The size and positioning of the liquid through-holes is exemplary. In general, the liquid through-holes are sized and positioned to enable circulation of the transfer fluid through the chamber(s), while not interfering with the components and traces on the printed circuit board.

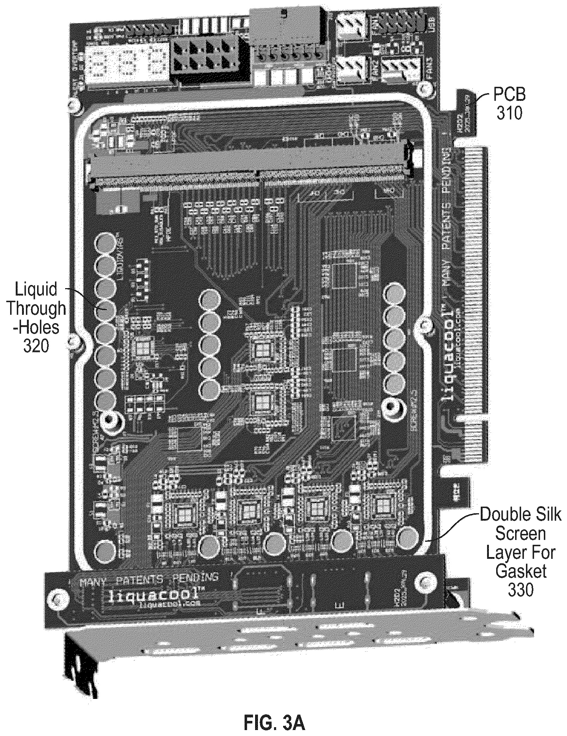

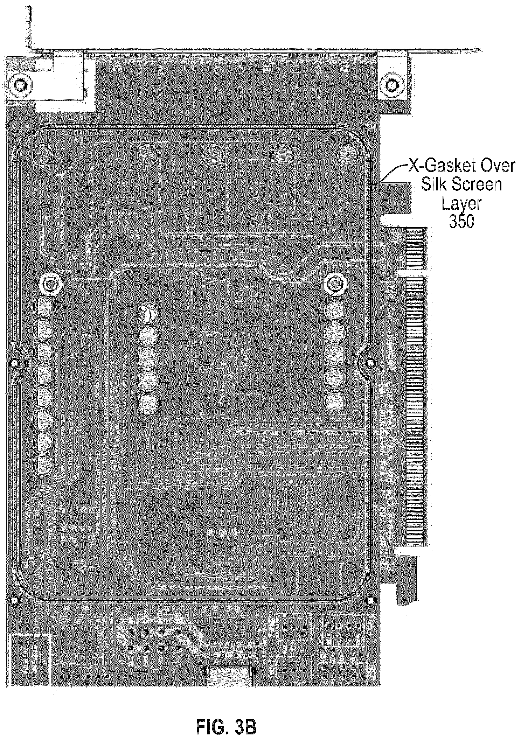

Figure 3A and 3B show illustrations of the front and back of an exemplary PCB 310, with the components removed. The liquid through holes 320 are distributed in multiple positions on the PCB 310. The liquid through holes 320 are positioned to maximize liquid flow within the chamber of the extended heatsink, to increase heat exchange between the liquid and the inside surface of the extended heatsink. The liquid through holes 320 are positioned to not interfere with any of the components or traces on the printed circuit board. Therefore, the liquid through-holes may move based on the PCB layout. When possible, there are a set of liquid through holes in close proximity, as shown here, with only small gaps between the holes. This increases liquid flow without impacting the structural integrity of the PCB. The extended heatsink, once attached, provides further support to the PCB, enabling a larger number of liquid through-holes without compromising the structural integrity of the PCB. In various embodiments, the liquid through-holes are metal plated, and couple to the ground plane in the PCB, to further dissipate heat through the ground plane.

In various embodiments, as shown in Figure 3A, there is a silk screen layer on the PCB, which is used to label components and other content on the PCB. Additionally, a silk screen layer is used around the edges of the extended heatsink to provide a silk screen path for the gasket. The silk screen layer 330 provides a liquid seal and engages with a gasket to provide leak-proof sealing of the extended heatsink to the PCB 310. In various embodiments, the silk screen layer providing the liquid seal is a double layer. Because the silk-screen layer is over traces in the PCB, it is not perfectly smooth. The double layer provides a smoother surface of the seal, as well as ensuring that there are no microscopic gaps in the silk screen layer under the gasket. Figure 3B shows one configuration of the board, showing the through-holes for the transfer fluid, and showing the X-gasket. In various embodiments, the gasket is an X-gasket. The X-gasket can replace a circular gasket. The X-gasket provides an additional layer of security for the leak-proof attachment because it has four separate contact areas. Other types of gasket configurations can also be used.

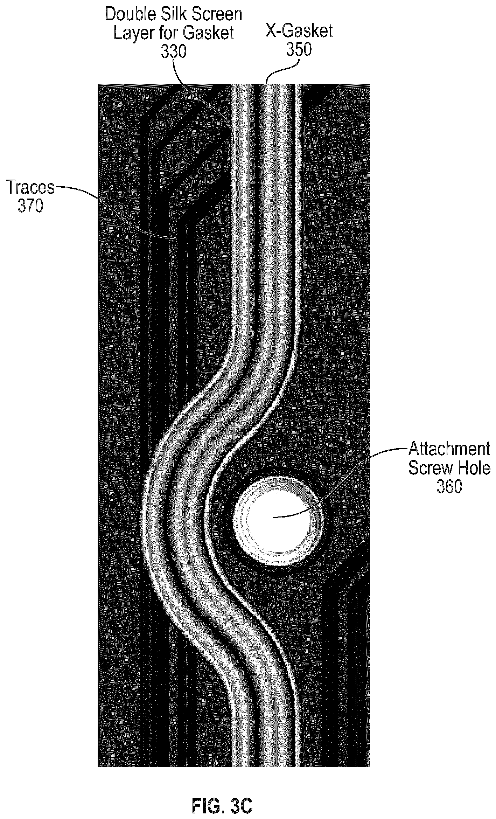

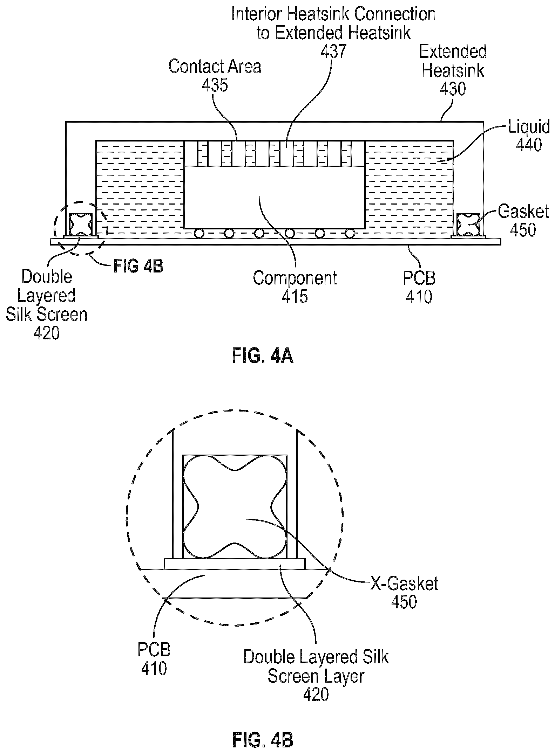

Figure 3C shows a close-up of the X-gasket of Figure 3B. The gasket 350 is routed around attachment screw holes/attachment screws 360, and goes around the entire extended heatsink, to provide a leak-proof seal. In various embodiments, the X-gasket 350 is placed on top of the double layer silk screen layer 330, which provides a smooth surface and also some liquid-proofing. As can be seen this this close-up, there are traces 370 underneath the silk screen layer 330. By doubling the silk screen layer, the silk screen is level despite passing over the traces 370 on the PCB. The X-gasket provides better sealing because there are effectively two layers of sealing between each component, due to the X-shaped cross-section (best seen in Figure 4B).

Figures 4A-4B show one example of an extended heatsink with an X-gasket for sealing the extended heatsink against a board. Figure 4A is a simplified crosscut of the extended heatsink and printed circuit board. A component 415 is mounted on the PCB 410. There is an extended heatsink 430 coupled to the PCB 410, comprising a contact area portion and an extended area or skirt which extends from the heatsink to the printed circuit board 410. The heatsink and skirt form the extended heatsink, which encloses a closed chamber filled with a transfer fluid 440. The interior surface of the extended heatsink also includes a contact area 435, which is formed by interior heatsink connection to the extended heatsink 437, is in contact with the top of component 415 to provide contact-based cooling. The form of the contact area may vary. The contact area may be solid, may include liquid through-holes, or may have fins or fingers, similar to a heatsink.

Thus, the system provides both contact-based cooling through contact area 435 of the extended heatsink and liquid cooling through transfer fluid 440 enclosed within the chamber formed by the extended heatsink. In various embodiments, the transfer fluid 440 flows in a convection pattern, moving heat from the component 415 to the interior surface extended heatsink 430. The exterior surface of the extended heatsink 430 includes fans, fins, and/or other elements to disperse the heat. Hotter materials or gasses rise, creating a temperature differential between the heated transfer fluid 440 and the cooler surface of the extended heatsink 430 which induces a flow of the transfer fluid within the chamber formed by the extended heatsink. In various embodiments, the transfer fluid may have one phase, meaning it remains in liquid form through the process. In other embodiments, the transfer fluid may transition between phases, from liquid to gas in locations where it is heated above its boiling point and then turn back into liquid again as the gas flows into a region where it is cooled down below its boiling point. The boiling point of the transfer fluid may be selected for optimal convection movement. In various embodiments, the boiling point may be 55 degrees Celsius. The boiling point may be selected based on the expected temperature range of the components being cooled. The use of a two-phase transfer fluid may increase the convection level, because gas rises faster than heated liquid, due to its lower density. In various embodiments, a perfluorinated compound (PFC) and/or perfluorocarbon may be used as the transfer fluid. In various embodiments, 3M^{™} Corporation's Fluorinert^{™} Electronic Liquid may be used as the transfer fluid.

The extended heatsink 430 is fastened securely to PCB 410 to ensure that none of the transfer fluid 440 in the chamber leaks. In various embodiments, this is accomplished by using a double layered silk screen 420 underneath a gasket 450. The gasket in various embodiments is an X-gasket which includes four protrusions, providing two close-fit seals at each side, as shown in the cross-section view of Figure 4B.

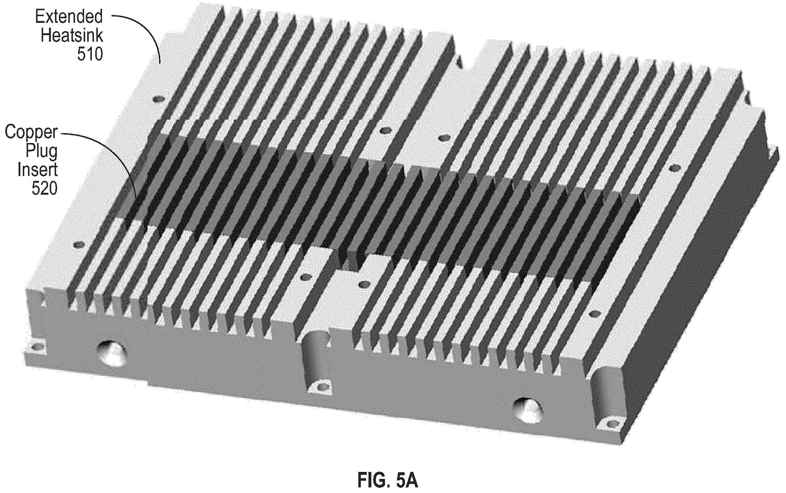

Figure 5A illustrates an example of the top of the extended heatsink showing a high heat conductivity area within the body of the extended heatsink. In this configuration, there is a plug of a higher heat conductance material 520 as part of the body of the extended heatsink. The plug 520 in various embodiments is red copper (copper with a high purity, for instance greater than 99.5% or 99.9%). The remaining portion of the extended heatsink 510 is a material with higher rigidity material such as aluminum in various embodiments. In various embodiments, the plug 520 is the portion of the extended heatsink in physical contact with a component to be cooled. Using aluminum with a red copper plug combines the structural strength of aluminum with the higher heat conductance of red copper. Although the example shown uses red copper and aluminum, the materials used may be different. In various embodiments, the entire extended heatsink may be made of a high heat conductance material, without a separate plug. In some other embodiments, the entire extended heatsink may be made of a single material, but there may be a plug to enable adjustment of the height of the contact area.

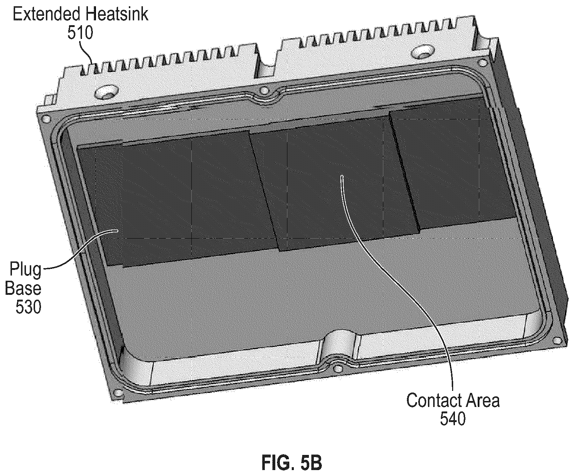

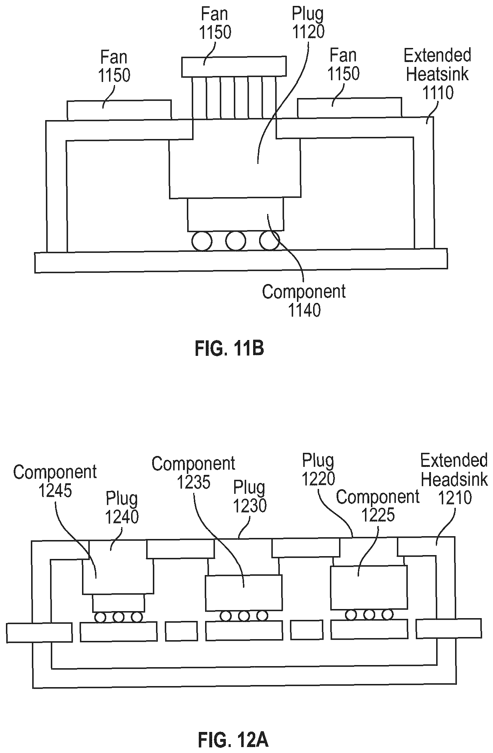

Figure 5B shows the interior of the extended heatsink of Figure 5A, showing the high conductivity plug. In this embodiment, the base of the plug 530 extends beyond the contact area 540. The height of the contact area 540 is sized for the component, such that the contact area 540 is in close proximity to the component. The contact area 540 touches the component directly. In various embodiments, a thermally conductive material may be placed between the contact area 540 and the top of the component. The thermally conductive material may be a thermal glue, thermal paste, thermal gel, thermal tape, thermal pad, thermal grease, thermal compound, a combination of these materials and/or other materials that have high thermal throughput. This thermal layer is designed to ensure that there are no microscopic gaps in the contact between the component and the contact area 540, and to provide good heat conductance and stability. It also permits some flexibility in the design of the plug base 530, which is sized to be in physical contact with the component, rather than requiring sub-millimeter precision. Although only a single contact area 540 is shown, a single extended heatsink may have multiple plugs, and/or multiple contact areas within a single plug, depending on the components within the extended heatsink, as illustrated in the examples of Figures 12A-12D below.

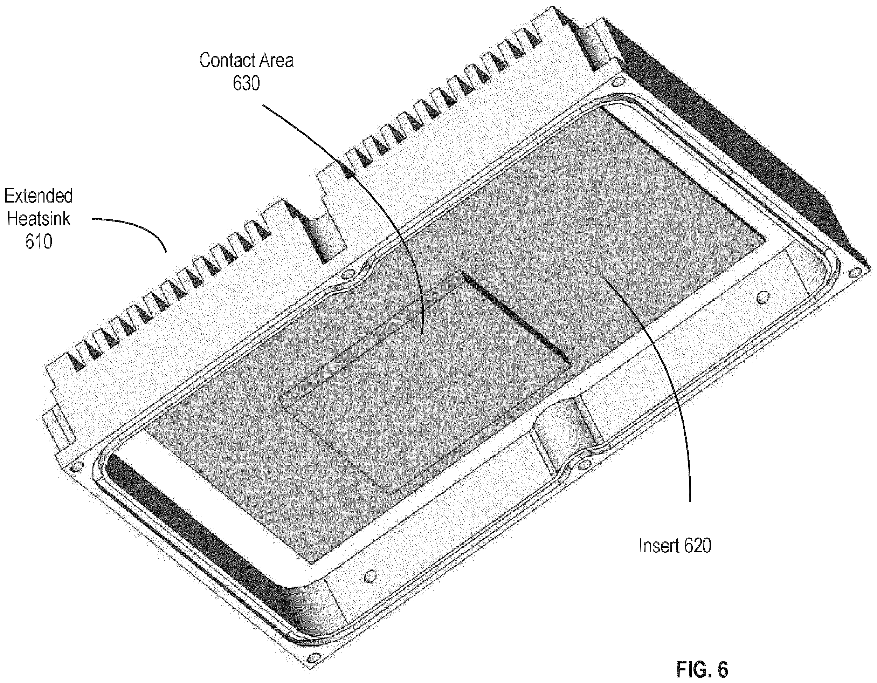

Figure 6 shows one example of the interior of the extended heatsink showing a high conductivity area extending over the entire interior. In this configuration, instead of a plug which extends through the extended heatsink, there is an insert 620 on the top of the extended heatsink 610. The insert includes a contact area 630, or as noted above multiple contact areas. In various embodiments, the insert 620 may extend only over a part of the interior of the extended heatsink. The insert may also extend along the side(s) of the extended heatsink. In various embodiments, the insert 620 may be two or more inserts, covering portions of the top of the extended heatsink.

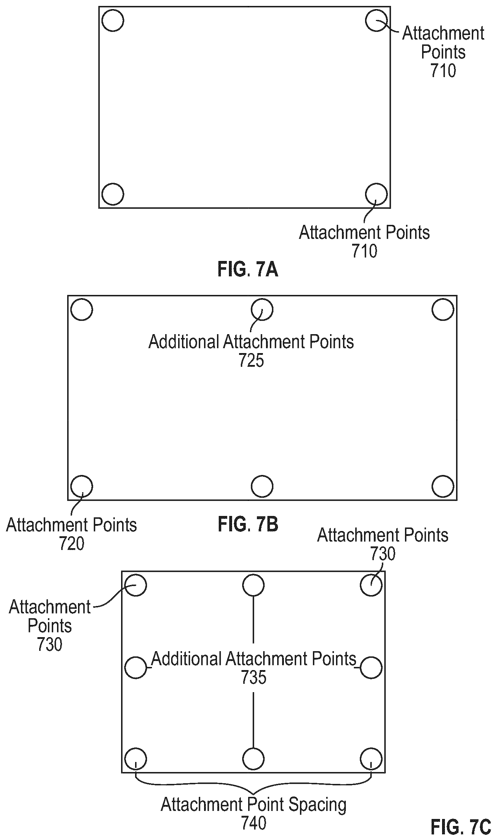

Figures 7A-7C illustrate various configurations of the attachment points for the extended heatsink, and attachment point spacing. The number of attachment points depends on a size of the extended heatsink. For a smaller extended heatsink, as shown in Figure 7A, four attachment points 710 at the four corners may be sufficient. For a larger rectangular extended heatsink, as shown in Figure 7B, additional attachment points 725 may be positioned between the corner attachment points 720. For a larger extended heatsink, as shown in Figure 7C, additional attachment points 735 may be positioned between attachment points 730. The attachment point spacing 740 is determined by the system based on a height and volume of liquid in the chamber of the extended heatsink. In various embodiments, the system can be set to minimize the number of attachment points, as long as the attachment points securely support the extended heatsink and provide a leak-proof system.

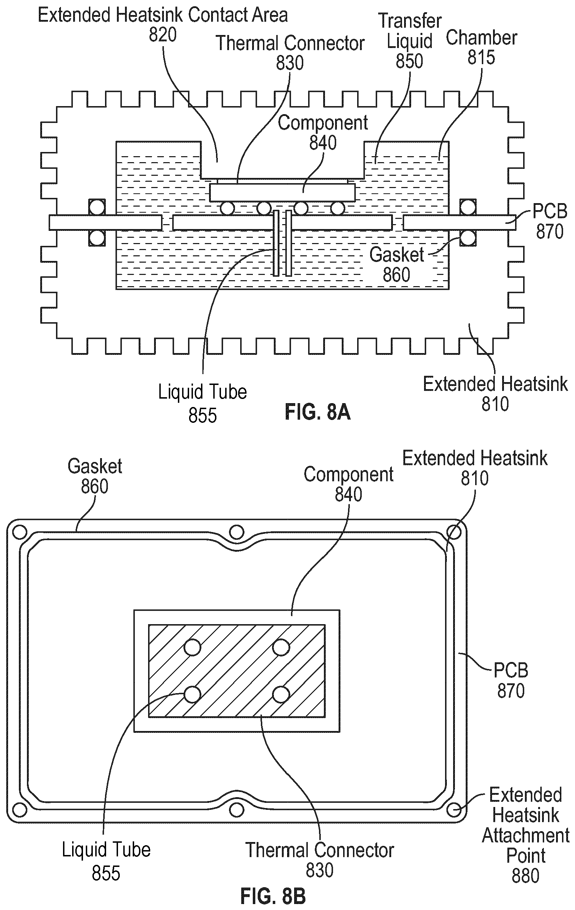

Figure 8A illustrates a cross-section of one configuration of the system including an extended heatsink with hybrid cooling, while Figure 8B illustrates a top view of the system of Figure 8A, showing a subset of the elements as transparent.

The system includes a printed circuit board 870 supporting a component 840. The printed circuit board includes a plurality of liquid through-holes 875, which allow the transfer fluid 850 to circulate in the chamber 815 formed by a top part of the extended heatsink 810 and the bottom part of the extended heatsink. In some embodiments, there is an air gap at the top of the chamber 815, to enable expansion of the liquid due to heat and/or phase change if the transfer fluid is a two-phase liquid.

The component 840 is cooled by the transfer fluid 850 as well as by contact with the contact area 820 of the extended heatsink. The contact area 820 is coupled to the component 840 using a thermal connector 830 in various embodiments. The thermal connector 830 may be thermal paste, a thermal pad, or another type of connector. In various embodiments, the thermal connector 830 is waterproof, and is not damaged by the transfer fluid 850. The gaskets 860 ensure that the attachment of the extended heatsink to the PCB is seamless and leak-proof. In various embodiments, for example as shown in Figure 8B, the gasket is around the edge of the PCB, defining the shape of the extended heatsink. The enclosing attachment points 880 are outside the gasket.

In various embodiments, there is a liquid tube 855 in the chamber, to pull colder liquid from the bottom of the chamber 815 to the component 840. The liquid tube 855 acts as a siphon and works due to the heat of the component 840. In various embodiments, the liquid tube 855 may be positioned below the component 840. In other embodiments, the liquid tube 855 may be positioned elsewhere to move liquid from cooler areas to hotter areas within the chamber 815.

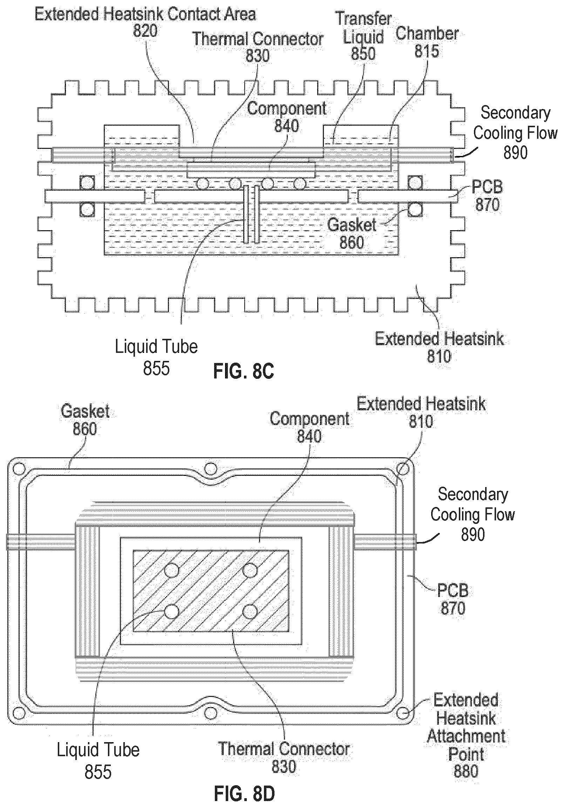

Figures 8C and 8D illustrate a cross section and top view of the system of Figure 8A, with the addition of a secondary cooling flow. In this configuration, an additional secondary cooling flow 890 has been added to the system. The secondary cooling flow utilizes a separate path for a coolant, which is isolated from transfer fluid 850. The secondary cooling flow 890 exits the extended heatsink 810 and is cooled by a cooler outside the system (not shown). While the secondary cooling flow 890 is illustrated with a circular tubing which has a single inflow and a single outflow for the fluid, alternative implementations may include curved portions, or additional inflow and/or outflow points. The coolant used does not need to be non-conductive and may be water or another liquid.

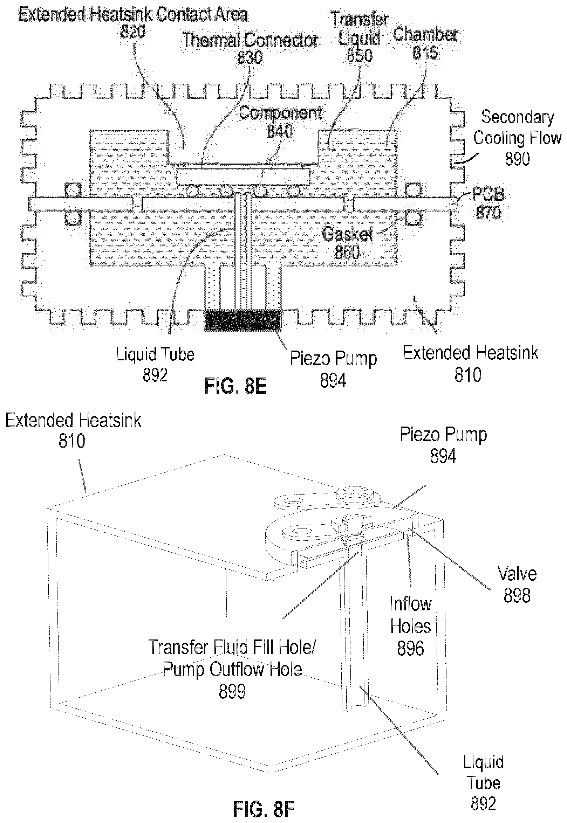

Figures 8E illustrates a cross section and top view of the system of Figure 8A, with an external piezoelectric pump. In this configuration, the flow in the liquid tube 892 is powered using a piezoelectric pump 894 as a liquid mover. The piezoelectric pump 894 in one embodiment includes an inflow area and pushes the transfer fluid out through liquid tube 892. This provides the cooling transfer fluid to the component and provides liquid flow.

Figure 8F illustrates a cross-section of the piezoelectric pump and liquid tube. The piezoelectric pump 894 is placed over the fill hole for the extended heatsink 810. The fill hole 899 includes the center fill hole which is used as the pump outflow hole. During the filling of the extended heatsink 810 with the transfer fluid, the fill hole 899 is used to add the transfer fluid, and the inflow holes 896 are the fill vents. When the piezoelectric pump 894 is operating, the pump pulls transfer fluid into its chamber through inflow holes 896 and pushes the transfer fluid out through liquid tube 892. Valve 898 ensures that the transfer fluid enters through the inflow holes 896 and exits through the liquid tube 892. The inflow holes 896, in various embodiments is a ring shape. The liquid tube 892 may be manufactured integrally with the extended heatsink 810, or may be a separate component, such as a tubing.

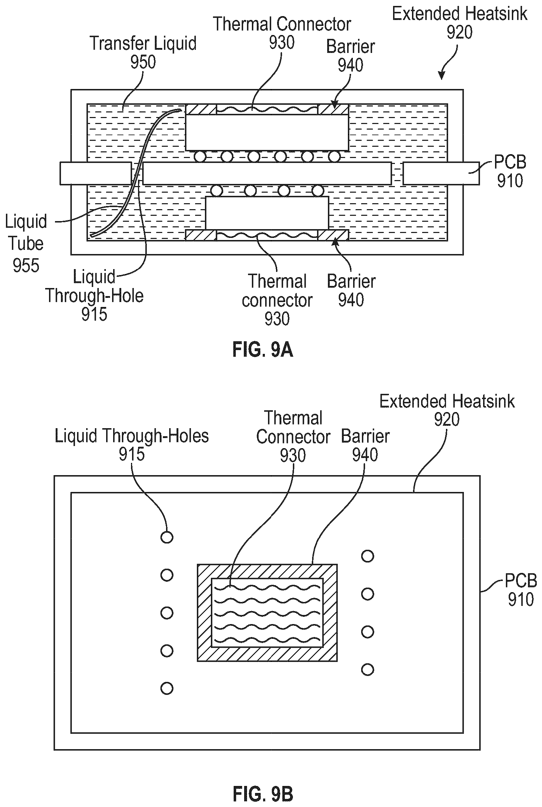

Figure 9A illustrates a cross-section of an exemplary configuration of the system including an extended heatsink with hybrid cooling, while Figure 9B illustrates a top view of the system of Figure 9A, showing a subset of the elements as transparent. In this configuration, there are components on both sides of the PCB 910 within extended heatsink 920. In this illustration, the extended heatsink does not include a plug. However, a dual sided configuration can also include a plug.

The components 950 are cooled by a transfer fluid as well as by contact with the contact areas of the extended heatsink. The contact areas in various embodiments are coupled to the component 940 using a thermal connector 930. In this configuration, the thermal connector is a paste or other material that is not liquid proof, and thus a barrier layer 940 is placed around the thermal connector 930, to isolate it from the transfer fluid 950 in the chamber. In some embodiments, the barrier layer 940 is also a thermal connector, such as thermal glue, while the thermal connector layer is a thermal grease, or another material with higher thermal conductance than the barrier layer. In another embodiment, the barrier layer may not be a thermal conductor material.

The liquid through-holes 915 in the PCB 910 allow circulation of the transfer fluid between the top and the bottom portions of the extended heatsink. The liquid through-holes are positioned in areas of the PCB 910 that are free of components or traces. In various embodiments, the liquid through-holes 915 are metal plated to increase heat conductance. The liquid through-holes may be coupled to the PCB ground plate.

In various embodiments, a liquid tube 955 is positioned to pull cool liquid from a cold location within the chamber of the extended heatsink 920 to the hot location in close proximity to the component. The liquid movement may be based on the difference in pressure between the cold liquid at the bottom and the hot liquid/gas at the top. In various embodiments, a liquid mover may be used to push water through the liquid tube 955. The liquid mover may be a piezoelectric pump, as illustrated in Figures 8D and 8E.

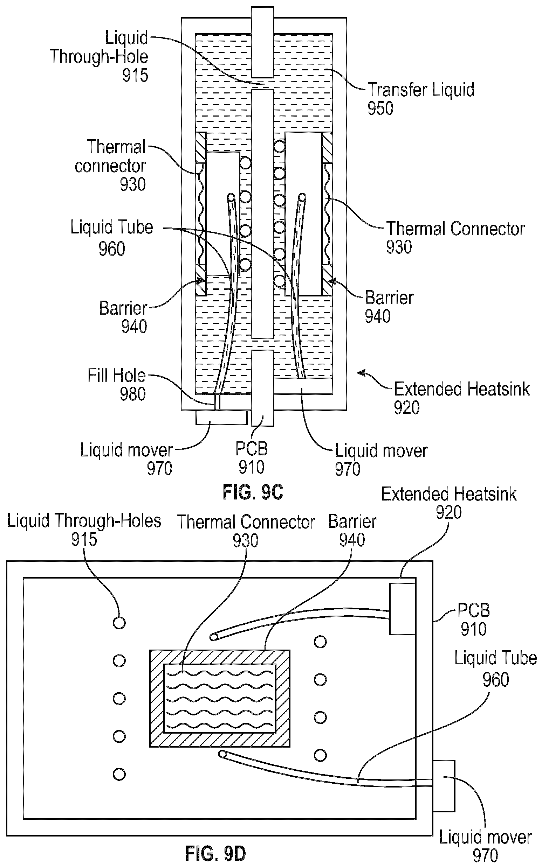

Figures 9C and 9D illustrate an alternative position of a liquid tube for a configuration in which the printed circuit board is positioned vertically. In this configuration, in various embodiments, a liquid mover 970 is used to move the liquid from the bottom of the extended heatsink 920 to the component which is producing the heat. In various embodiments, the liquid mover 970 is within the extended heatsink 920, pushing liquid through the liquid tube 960. In other embodiments, the liquid mover 970 maybe outside the extended heatsink 920 as shown, and the liquid mover 970 may provide power to move the liquid through the liquid tube 960. When the liquid mover 970 is outside the extended heatsink 920, the connection may be through the fill hole 980 used to fill the chamber with the transfer fluid. The liquid mover 970 may be a piezoelectric motor. By placing the liquid mover 970 outside the extended heatsink 920, the liquid mover 970 can be serviced in situ without opening the extended heatsink. In another configuration, there may not be a liquid mover, and the difference in pressure may be used. The liquid mover may also be used in the configurations of Figures 8A-8D, or other configurations shown.

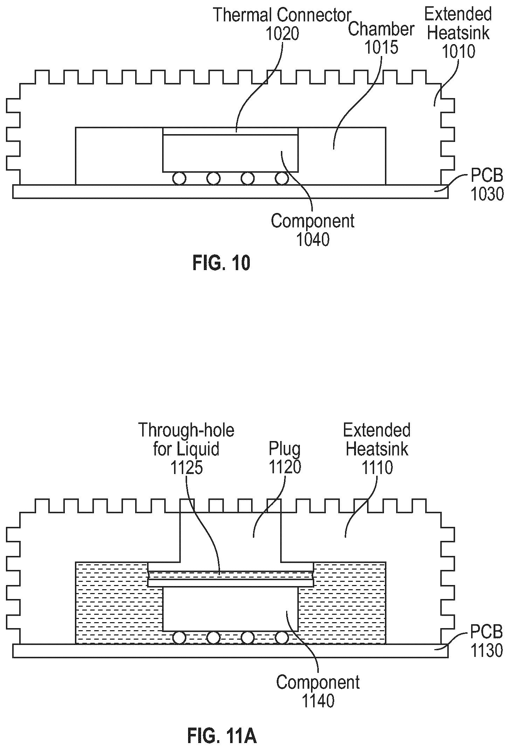

Figure 10 illustrates a configuration of a single-sided hybrid cooling system. In this configuration, the extended heatsink 1010 has a chamber 1015 with a flat interior, rather than a raised contact area. A thermal connector 1020 couples the contact area of the extended heatsink 1010 to component 1040 on the PCB 1030. There is no bottom portion of the extended heatsink, and thus no liquid through-holes. The disadvantage of this configuration is that it requires a specific design for each PCB, because the extended heatsink height is designed to match the height of the component 1040. Although not shown here, the interior of the extended heatsink may have multiple heights, to account for the configuration of multiple components on the PCB 1030.

Figure 11A illustrates a single-sided hybrid cooling system with a plug. In this configuration, the extended heatsink 1110 on the PCB 1130 includes a plug 1120, which extends from the interior of the extended heatsink1110 to the exterior of the extended heatsink. The plug 1120 includes a contact area, which can be raised, to match the height of the component 1140. The plug 1120 in various embodiments is made of a highly heat conductive material, such as red copper. Alternatively, the plug 1120 may be made of the same material as the extended heatsink 1110. In various embodiments, the plug 1120 has a through-hole 1125 through which the transfer fluid within the chamber can pass. The through-hole in the plug consists of one or more holes which allow the transfer fluid to pass through. The through-holes 1125 through the plug 1120 facilitate circulation of the transfer fluid. Although the through-hole 1125 is illustrated in a single-sided extended heatsink, such through-holes 1125 may be used in any configuration of the extended heatsink that includes a plug which extends past the interior surface of the extended heatsink 1110.

Figure 11B illustrates a configuration of the single-sided hybrid cooling system with a plug, showing a plurality of fans. The fans can be used to increase airflow across the exterior of the extended heatsink 1110, to make cooling more effective. One or more fans 1150 may be coupled to the extended heatsink or be in close proximity to it. In various embodiments, the extended heatsink and/or plug 1120 may have fins extending above a top of the extended heatsink 1110. In various embodiments, a fan 1150 may be associated with the plug, to increase air flow specifically on the fins of the plug 1120.

Figure 12A illustrates one exemplary configuration of a multi-component system including plugs. In the illustrated configuration, there are a plurality of components within the extended heatsink 1210, and the extended heatsink 1210 includes a plurality of plugs 1220, 1230, 1240, each associated with a component 1225, 1235, 1245, respectively. As can be seen, the interior of the extended heatsink 1210 has a level surface, but the plugs 1220, 1230, 1240 have different heights, to account for the different sizes of the components 1225, 1235, and 1245. This enables the system to support contact-based cooling for a plurality of components of different heights without redesigning the extended heatsink itself 1210, by varying the plug sizes. This type of plug configuration may be used with a single sided extended heatsink, as illustrated, as well as a dual sided extended heatsink. Although the illustration shows three components, one of skill in the art would understand that a single extended heatsink may support any number of components, with or without plugs.

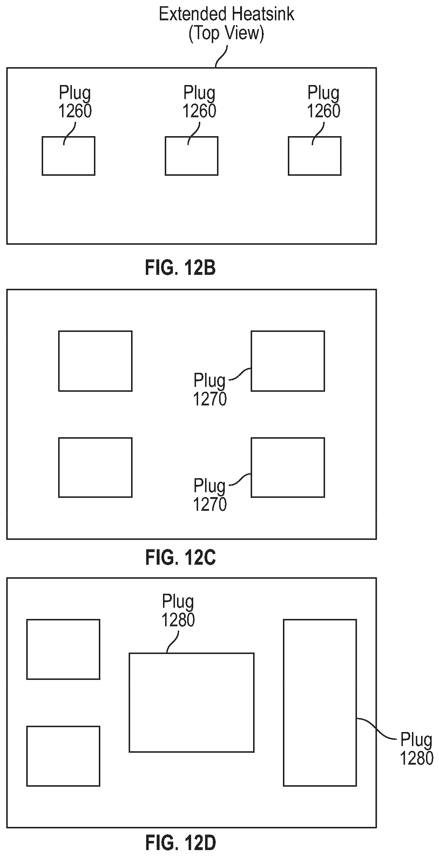

Figures 12B-12D illustrate top/bottom views of various configurations of the extended heatsink showing placements of plugs. In the first configuration shown in Figure 12B, there are three components in a row, similar to the configuration illustrated in Figure 12A, each associated with a plug 1260. In the configuration of Figure 12C, there are four components, arranged in regular arrangement, and each of the components is the same size, and has an associated plug 1270. In the configuration of Figure 12D there are five plugs 1280, and each is a different size, based on the size of the corresponding component which is cooled by that plug. It should be understood that the present application is not limited to any particular number of components within an extended heatsink, or a particular size of plug. In various embodiments, the plug may be sized to cover the entire top of a component and extend beyond the edges of the component. In alternative embodiments, the plug may be sized to be exactly the same size as the component or smaller. Additionally, these views are top/bottom views, as they may illustrate either a top or a bottom portion of an extended heatsink.

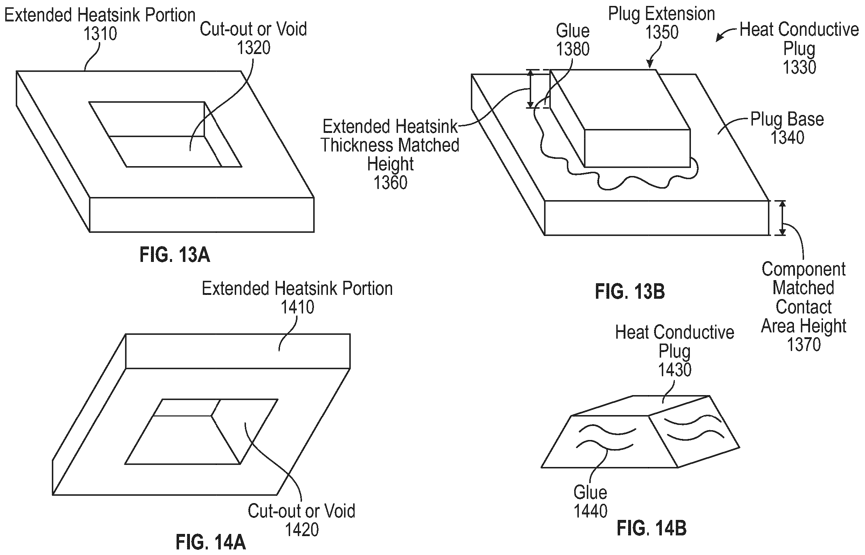

Figures 13A and 13B illustrate one configuration of a portion of the extended heatsink, and an associated plug. The portion of the extended heatsink 1310 illustrated includes a void or cut-out 1320 for the conductive plug. In some embodiments, the extended heatsink is manufactured in a single piece, and a void 1320 is cut out of the extended heatsink based on the size, position, and configuration of the component(s) on the PCB that the extended heatsink is designed-for. In various other embodiments, the extended heatsink may be manufactured with the void 1320, or the void may be generated in another way. The heat conductive plug 1330 is designed to have a plug extension 1350 which fits into the void 1320, and a plug base 1340 which is on the interior of the extended heatsink 1320 and provides the contact area for the component(s). The plug base has a component-matched height 1370, enabling the heat conductive plug 1330 to be in direct contact with the component. The plug extension 1350 has a height 1360 matched to the thickness of the extended heatsink. In various embodiments, the top of the extended heatsink is flat, and the plug 1330 does not extend beyond the extended heatsink's top. In some embodiments, the top of the extended heatsink may have fins or other cooling structures, and the plug may have matching fins or other structures. The plug 1330 may be glued into the extended heatsink 1310, using glue 1380, or may be attached using another mechanism, such as pressure fitting.

Figures 14A and 14B illustrate an alternative configuration of the plug, showing of a portion of the extended heatsink, and an associated plug. The extended heatsink portion 1410 includes the void 1420. The void 1420 is shaped to fit a plug 1430. In some embodiments, the sides of the plug are angled, to provide a more secure fit into the void in the extended heatsink 1410. The heat conductive plug 1430 is designed to have a wider bottom surface, in contact with the component, and a narrower top surface extending to the top of the extended heatsink 1410. The plug 1430 is glued into the extended heatsink, using glue 1440.

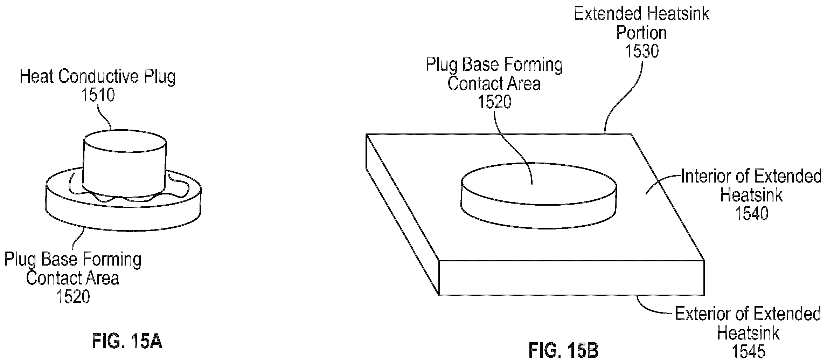

Figures 15A and 15B illustrate another alternative configuration of the plug, showing a portion of the extended heatsink, and an associated plug. Figure 15A illustrates a plug 1510 with a plug base 1520 which is the contact area for a component within the chamber formed by the extended heatsink. The extended heatsink portion 1530 receives the plug, as shown in Figure 15B. The plug base 1520 extends from the interior 1540 of the extended heatsink. The plug extension which goes through the extended heatsink 1530 in various embodiments is flush with the exterior of the extended heatsink 1545. In another configuration, the plug may extend beyond the top of the extended heatsink. In this illustration, the plug base and plug extension are both round.

In the prior example illustrations, the shapes included a square, a rectangle, a cone, and a frustrum. However, the shape of the plug is not limited by these examples. The plug may be any shape that is appropriate for the component it is cooling. In some embodiments, the base and extension of the plug may be different shapes. In some embodiments, the plug may not have a separate base and extension, for example as shown in Figures 14A and 14B. The present system can in various embodiments utilize a customized plug for the components being cooled, enabling contact-based cooling, in addition to liquid cooling, within an extended heatsink.

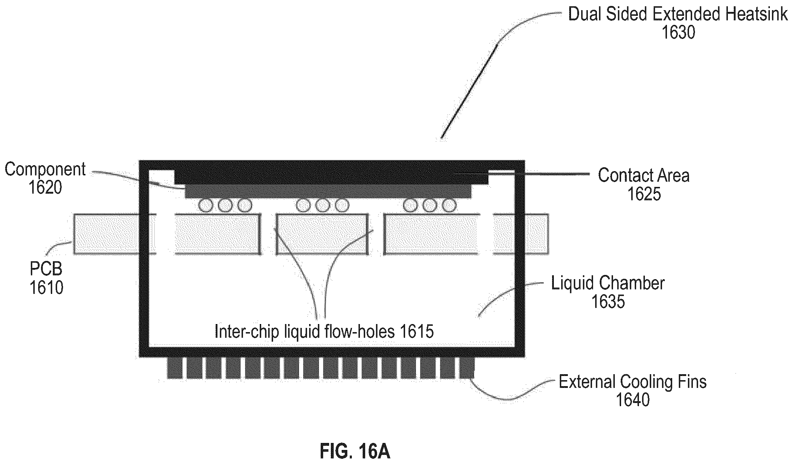

Figure 16A illustrates a cross-section of the system including intra-chip holes for liquid cooling. In this configuration, there is a dual sided extended heatsink 1630 forming a liquid chamber 1635 to cool a component 1620 on a PCB 1610. The extended heatsink 1630 has a contact area 1625 which is in contact with a top portion of the component 1620. In addition to the contact-based cooling through contact area 1625, the system provides liquid cooling of the other portions of the component 1620 through transfer fluid filling the chamber formed by the extended heatsink. In this configuration, the PCB 1610 includes a plurality of inter-chip liquid flow-holes 1615, which allow the transfer fluid in the chamber 1635 to flow between the connection pins underneath the component 1620. Although a BGA (ball grid array) component 1620 is shown, the connection pins of the component 1620 may vary. The inter-chip liquid flow-holes 1615 enable the system to use the transfer fluid to cool the connection pins and the bottom of the component 1620 in addition to the top and sides.

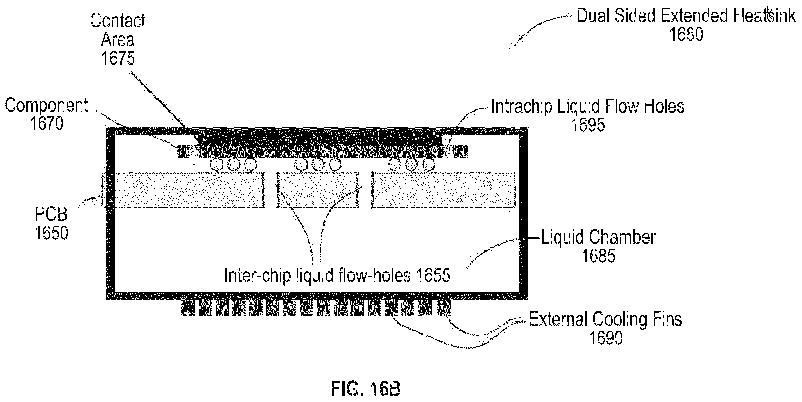

Figure 16B illustrates a cross-section of one configuration of the system including intra-chip holes for liquid cooling. In this configuration, there is an extended heatsink 1680 forming a liquid chamber 1685 to cool a component 1670 on a PCB 1650. The extended heatsink 1680 has a contact area 1675 which is in contact with a top portion of the component 1670. In addition to the contact-based cooling through contact area 1675, the system provides liquid cooling of the other portions of the component 1670 through transfer fluid within the chamber formed by the extended heatsink. In this configuration, the system includes intra-chip liquid flow-holes 1695 through the component packaging. This places the transfer fluid cooling in closer proximity to the actual heat source (the component's working parts). Although a BGA (ball grid array) component 1670 is shown, the attachment mechanism of the component 1670 may vary. The intra-chip liquid flow holes 1695 provide cooling within the component itself. In various embodiments, the system may have intra-chip liquid flow-holes 1695 but not inter-chip liquid flow holes 1655. The intra-chip cooling may be combined with inter-chip liquid flow-holes 1655, optionally, in a dual-sided extended heatsink.

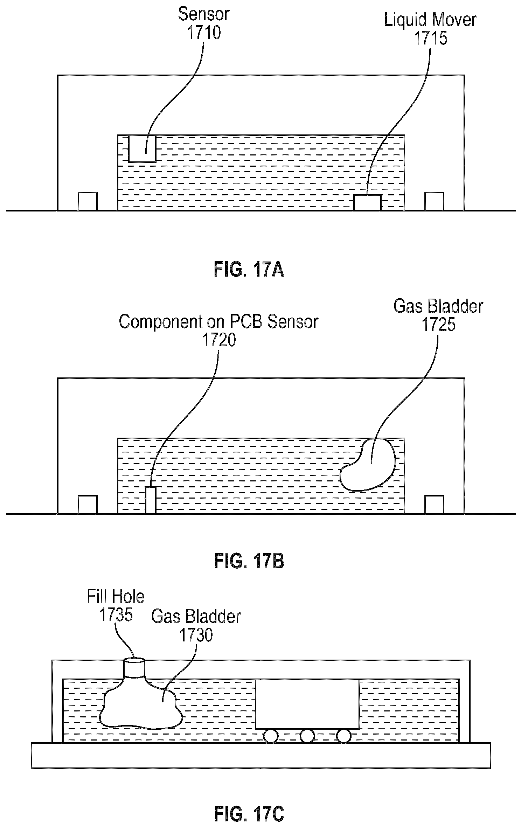

Figures 17A-17L show various configurations of the extended heatsink with additional objects within the chamber. Such components may include one or more of a sensor, a gas bladder, and a liquid mover. Figure 17A illustrates an extended heatsink with a sensor 1710 and a liquid mover 1715 within the chamber of the extended heatsink. The sensor 1710 may be coupled to the extended heatsink or the printed circuit board. The sensor may be a pressure and/or temperature sensor. The output of sensor 1710 may be made available outside of the extended heatsink to a user. For example, a user may be able to monitor the internal temperature of the components and/or the transfer fluid within the extended heatsink, to ensure that the components are at the optimal temperature for processing. The output of sensor 1710 may be additionally or instead used to control a liquid mover or a gas bladder, as will be described below.

The system may further include one or more liquid movers 1715 within the extended heatsink. Transfer fluid moves through the extended heatsink due to the fact that when heated the transfer fluid becomes less dense and thus rises, and as it is cooled by contact with the extended heatsink, it falls. This creates a convection movement of the transfer fluid within the chamber of the extended heatsink. However, a liquid mover 1715 may be optionally added within the chamber of the extended heatsink. The liquid mover 1715 may be for example an integrated micropump to actively circulate the transfer fluid, a vibration motor within the sealed chamber created by the extended heatsink to create mechanical agitation, a small submerged fan or propeller, a piezoelectric motor, a thermoelectric cooler (TEC) within the extended heatsink to create a temperature gradient, promoting fluid movement through thermal cycling, a speaker to generate acoustic waves, a piezoelectric buzzer to create ultrasonic vibrations, a piezoelectric buzzer, a piezoelectric diaphragm pump, or another structure for promoting the movement of the transfer fluid. Such liquid movers may be used with all configurations of the extended heatsink, single sided or double sided, as well as all configurations of the flow-holes described above. In various embodiments, the output of the sensor 1710 may be used to adjust the liquid mover 1715, to dynamically adjust the flow of the transfer fluid.

Figure 17B illustrates the optional addition of a gas bladder 1725 to the chamber of the extended heatsink. There is a relationship between temperature, pressure, and volume, as the temperature rises so does the volume of the transfer fluid which may be a two-phase fluid. The gas bladder 1725 is used to adjust the pressure and thereby influence the temperature within the chamber of the extended heatsink. In various embodiments, the gas bladder 1725 enables the chamber to be partially filled with the transfer fluid, with the remaining volume filled by the gas bladder. This also provides a way to relieve pressure, since the gas is compressed by the transfer fluid (or transfer gas) as it expands due to heat, because it is less dense.

Figure 17C illustrates configuration in which the gas bladder 1730 has a fill hole 1735. This enables the system to adjust the pressure, and thus the temperature by adjusting the volume of gas in the gas bladder 1730, not merely compressing the existing volume of gas. This provides even more flexibility than the compressible gas in the bladder. In various embodiments, there may be an automatic filling/emptying system, which can automatically adjust the volume of the gas bladder 1730 based on the temperature/pressure data from the sensor.

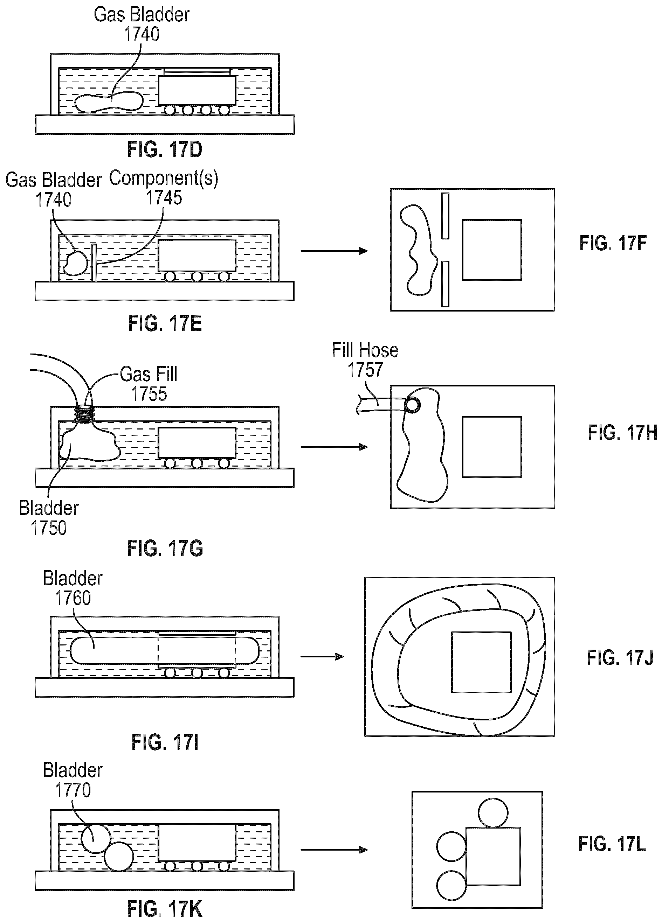

Figures 17D-17L illustrate various configurations of the gas bladder that may be used. The configurations include a gas bladder positioned behind some components, as shown in Figure 17E/17F, alongside a component as shown in Figure 17G/17H, around the component as shown in Figure 17I/17J, or as multiple separate components as shown in Figure 17K/17L. Other alternative configurations of the gas bladders may be used. The gas fill 1755 may be added to any of the configurations shown, to provide external adjustability of the gas bladder. In various embodiments, the gas bladder is filled with a highly thermally conductive gas. In various embodiments, it is filled with a gas that is highly compressible and lighter than the gaseous form of the transfer fluid. In various embodiments, the gas bladder is filled with nitrogen which is highly compressible and a good conductor of heat.

In the foregoing specification, the invention has been described with reference to specific exemplary embodiments thereof. It will, however, be evident that various modifications and changes may be made thereto without departing from the broader spirit and scope of the invention as set forth in the appended claims. The specification and drawings are, accordingly, to be regarded in an illustrative rather than a restrictive sense.

The claims define the matter for protection.

Additionally, aspects of this specification provide the following.
1. A hybrid cooling system comprising:
   a printed circuit board having a component mounted thereon;
   an extended heatsink coupled to the printed circuit board and forming a sealed chamber with the printed circuit board, the extended heatsink having an interior surface and an exterior surface;
   a contact area, being a portion of the interior surface of the extended heatsink, being in direct physical contact with a top surface of the component; and
   a transfer fluid within the sealed chamber.
2. The hybrid cooling system of claim 1, further comprising:
   a thermal connector between the contact area and the top surface of the component.
3. The hybrid cooling system of claim 2, wherein the thermal connector comprises one of: a thermal pad, thermal grease, and thermal glue.
4. The hybrid cooling system of any preceding claim, further comprising:
   a plug on which is provided the contact area, the plug made of a material having a higher coefficient of thermal conductivity than the extended heatsink.
5. The hybrid cooling system of claim 4, wherein the plug has a portion that extends from the interior surface of the extended heatsink, the portion that extends from the extended heatsink including the contact area.
6. The hybrid cooling system of claim 4 or claim 5, wherein the plug extends along a top interior surface of the extended heatsink.
7. The hybrid cooling system of any of claims 4 to 6, further comprising:
   a cut-out in the extended heatsink for the plug.
8. The hybrid cooling system of any of claims 4 to 7, wherein a top of the plug is flush with the extended heatsink surface of the extended heatsink.
9. The hybrid cooling system of any of claims 4 to 8, wherein the plug comprises red copper, and the extended heatsink comprises aluminum.
10.The hybrid cooling system of any preceding claim, further comprising:
   one or more fans mounted on the exterior of the extended heatsink.
11.The hybrid cooling system of any preceding claim, further comprising:
   a plurality of additional components on the printed circuit board; and
   a plurality of additional contact areas on the interior of the extended heatsink, each corresponding to a different one of the plurality of additional components.
12.The hybrid cooling system of any preceding claim, further comprising:
   an X-gasket located to provide a seal between the extended heatsink and the printed circuit board.
13.The hybrid cooling system of any preceding claim, further comprising:
   a sensor within the sealed chamber to sense one or more of: pressure and temperature, the sensor having an output available outside of the extended heatsink.
14.The hybrid cooling system of claim 13, further comprising:
   a bladder filled with a gas within the sealed chamber, wherein the bladder is able to expand and contract to facilitate a balance of pressure within the sealed chamber.
15.The hybrid cooling system of claim 14, further comprising:
   the bladder having an inlet on the exterior of the extended heatsink, for enabling adjustment of the gas within the bladder.
16.The hybrid cooling system of any preceding claim, further comprising:
   a gasket arranged to seal the extended heatsink to the printed circuit board; and
   a silk screen layer arranged to label components on the printed circuit board and/or providing a silk screen path being a liquid barrier and a smooth surface over PCB traces for sealing with the gasket.
17.The hybrid cooling system of claim 16, wherein the silk screen path comprises a double layer of silk screen material.
18.The hybrid cooling system of any preceding claim, wherein the extended heatsink is coupled to the printed circuit board using a plurality of screws, the number of screws being appropriate to the size of the extended heatsink.
19. The hybrid cooling system of any preceding claim, further comprising:
   the extended heatsink comprising a double sided extended heatsink with a first portion on a top of the printed circuit board and a second portion on a bottom of the printed circuit board; and
   through-holes in the printed circuit board for allowing the liquid to circulate between the first portion and the second portion of the extended heatsink.
20.The hybrid cooling system of claim 19, wherein i) one or ii) both of the top portion and the bottom portion are provided with the contact area on the interior surface.
21.The hybrid cooling system of claim of any preceding claim further comprising:
   a fill hole to fill the transfer fluid into the chamber formed by the extended heatsink; and
   a seal to securely close the fill hole, to create the sealed chamber.
22.The hybrid cooling system of claim 21, further comprising:
   a vent hole; and
   a piezoelectric pump functioning as the seal to cover the fill hole and the vent hole, the piezoelectric pump used as a liquid mover.
23.The hybrid cooling system of claim 22, wherein the piezoelectric pump output comprises a liquid tube to move the transfer fluid.
24.The hybrid cooling system of claim 21, further comprising:
   a bolt and an O-ring functioning as the seal to close the fill hole.
25.The hybrid cooling system of claim 24, wherein the bolt is screwed into a recessed bolt hole into which the O-ring fits, and the bolt is a flanged bolt.
26. The hybrid cooling system of any preceding claim, further comprising:
   a liquid tube to move the transfer fluid from a cooler region in the sealed chamber to the component.
27.The hybrid cooling system of claim 26, wherein the liquid tube is a siphon and the transfer fluid flows by hotter material rising.
28. The hybrid cooling system of claim 26, wherein the liquid tube is powered by a liquid mover.
29. The hybrid cooling system of claim 27, wherein the liquid mover is inside the sealed chamber.
30. The hybrid cooling system of claim 27, wherein the liquid mover is outside the sealed chamber.
31. The hybrid cooling system of claim 30, wherein the liquid mover uses a fill hole and a vent hole in the enclosed heatsink to pump the transfer fluid.
32. The hybrid cooling system of claim 26, wherein the liquid mover comprises one of an integrated micropump, a vibration motor, a submerged fan, a submerged propeller, a piezoelectric motor, a thermoelectric cooler, a speaker, a piezoelectric buzzer, or a piezoelectric diaphragm pump.
33. The hybrid cooling system of any of the preceding claims wherein the printed circuit board is vertical.
34.The hybrid cooling system of any of the preceding claims wherein the contact area includes a liquid through-hole so that the transfer fluid can flow through the liquid through-hole in the contact area.
35.The hybrid cooling system of any of the preceding claims further comprising:
   a first plug to form the contact area to provide contact cooling for a first component on the printed circuit board; and
   a second plug to from a second contact area to provide the contact cooling for a second component on the printed circuit board.
36. The hybrid cooling system of claim 35, wherein the plurality of plugs are different sizes.
37.The hybrid cooling system any of the preceding claims, further comprising:
   the enclosed heatsink having a top portion attached to a first side of the printed circuit board and a bottom portion attached to a second side of the printed circuit board.
38.The hybrid cooling system of claim 37, further comprising:
   a first plug to form the contact area to provide contact cooling for a first component on the printed circuit board coupled to the first side of the printed circuit board; and
   a second plug to from a second contact area to provide the contact cooling for a second component on the printed circuit board coupled to the second side of the printed circuit board.
39. The hybrid cooling system of any of the preceding claims, further comprising:
   a secondary cooling flow through the extended heatsink, the secondary cooling flow having a coolant that is different from the transfer fluid, to cool the transfer fluid.
40.The hybrid cooling system of claim 39, wherein the coolant is water.
41.The hybrid cooling system of claim 39, further comprising:
   a cooler to chill the coolant in the secondary cooling flow, wherein the coolant passes through a path from the cooler through the extended heatsink and back to the cooler.
42. The hybrid cooling system of claim 39, wherein the secondary cooling flow passes through the sealed chamber of the extended heatsink, and around the component.

## Claims

1. A hybrid cooling system coupled to a printed circuit board to provide cooling for a component mounted on the printed circuit board, the hybrid cooling system comprising:
an extended heatsink coupled to the printed circuit board to form a sealed chamber with the printed circuit board, the extended heatsink comprising a heatsink with a skirt extending from the heatsink, the skirt coupled to the printed circuit board, the extended heatsink having an interior surface and an exterior surface;
a contact area on the interior surface of the extended heatsink, the contact area designed to be in direct physical contact with a top of the component, to provide direct contact cooling to the component; and
a transfer fluid within the sealed chamber and contacting other areas of the component mounted on the printed circuit board to provide liquid cooling for the component.

2. The hybrid cooling system of claim 1, further comprising:
a thermal connector between the contact area and the top of the component, wherein the thermal connector optionally comprises one of: a thermal pad, thermal grease, and thermal glue.

3. The hybrid cooling system of any preceding claim, further comprising:
a plug forming the contact area, the plug optionally made of a material having a higher coefficient of thermal conductivity than the extended heatsink.

4. The hybrid cooling system of any preceding claim, wherein the plug has a portion that extends from the interior surface of the extended heatsink, the portion that extends from the extended heatsink forming the contact area.

5. The hybrid cooling system of claim 3-4, wherein the plug extends along a top interior surface of the extended heatsink.

6. The hybrid cooling system of claim 3-5, further comprising:
a cut-out in the extended heatsink for the plug, and optionally wherein a top of the plug is flush with the extended heatsink surface of the extended heatsink.

7. The hybrid cooling system of claim 3-6, wherein the plug comprises red copper, and the extended heatsink comprises aluminum.

8. The hybrid cooling system of any preceding claim, further comprising:
one or more fans mounted on the exterior of the extended heatsink.

9. The hybrid cooling system of claim any preceding claim, further comprising:
a plurality of additional components on the printed circuit board; and
a plurality of additional contact areas on the interior of the extended heatsink, for the plurality of additional components.

10. The hybrid cooling system of claim any preceding claim, further comprising:
an X-gasket between the extended heatsink and the printed circuit board, to provide a leak-proof seal.

11. The hybrid cooling system of claim any preceding claim, further comprising:
a sensor within the sealed chamber to sense one or more of: pressure and temperature, the sensor having an output available outside of the extended heatsink.

12. The hybrid cooling system of claim any preceding claim, further comprising:
a bladder filled with a gas within the sealed chamber, wherein the bladder expands and contracts to facilitate a balance of pressure within a sealed chamber,
the bladder optionally having an inlet on the exterior of the extended heatsink, enabling adjustment of the gas within the bladder.

13. The hybrid cooling system of claim any preceding claim, further comprising:
a gasket sealing the extended heatsink to the printed circuit board;
a silk screen layer to label components on the printed circuit board and to provide a silk screen path for the gasket, the silk screen path providing a liquid barrier and a smooth surface over PCB traces for sealing with the gasket, wherein the silk screen path optionally comprises two superimposed layers for sealing smoothness and trace coverage.

14. The hybrid cooling system of claim any preceding claim, wherein the extended heatsink is coupled to the printed circuit board using a plurality of screws, and a number of screws is adjusted based on a size of the extended heatsink.

15. The hybrid cooling system of claim any preceding claim, further comprising:
the extended heatsink comprising a double sided extended heatsink with a first portion on a top of the printed circuit board and a second portion on a bottom of the printed circuit board, wherein one or both of the top portion and the bottom portion have the contact area on the interior surface; and
through-holes in the printed circuit board to allow the liquid to circulate between the first portion and the second portion of the extended heatsink.
